(19)

Europäisches Patentamt
European Patent Office
Office européen des brevets

(11) **EP 4 279 994 A1**

(12) **EUROPEAN PATENT APPLICATION**

(43) Date of publication:
**22.11.2023 Bulletin 2023/47**

(21) Application number: **22174619.1**

(22) Date of filing: **20.05.2022**

(51) International Patent Classification (IPC):
$G03F\ 7/20^{(2006.01)}$ $\quad$ $G01N\ 21/88^{(2006.01)}$
$G01N\ 21/95^{(2006.01)}$ $\quad$ $G01N\ 21/956^{(2006.01)}$

(52) Cooperative Patent Classification (CPC):
**G03F 7/70625; G01N 21/8806; G01N 21/9501;**
**G01N 21/956; G03F 7/70633**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **WARNAAR, Patrick**
**5500 AH Veldhoven (NL)**
• **ZHOU, Zili**
**5500 AH Veldhoven (NL)**

(74) Representative: **ASML Netherlands B.V.**
**Corporate Intellectual Property**
**P.O. Box 324**
**5500 AH Veldhoven (NL)**

(54) **ILLUMINATION MODULE AND ASSOCIATED METHODS AND METROLOGY APPARATUS**

(57) Disclosed is an illumination module for a metrology device. The illumination module comprises a configurable illumination module operable to provide measurement illumination over a configurable range of illumination angles, a grating light valve module (GLV) for controllably configuring a spectral configuration of the measurement illumination; and a controller operable to control the configurable illumination module and the grating light valve module such that the spectral configuration of the measurement illumination is varied in dependence with illumination angle within the range of illumination angles so as to obtain a desired detection condition for detection of diffracted radiation from a diffractive structure resultant from a measurement of the diffractive structure using the measurement illumination.

Fig. 10

**Description**

<u>BACKGROUND</u>

Field of the Invention

The present invention relates to methods and apparatus usable, for example, in the manufacture of devices by lithographic techniques, and to methods of manufacturing devices using lithographic techniques. The invention relates more particularly to metrology sensors and lithography apparatuses having such a metrology sensor, and more particularly still to illumination arrangements for such metrology sensors.

Background Art

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor, typically an optical position sensor. The lithographic apparatus includes one or more alignment sensors by which positions of marks on a substrate can be measured accurately. Different types of marks and different types of alignment sensors are known from different manufacturers and different products of the same manufacturer.

In other applications, metrology sensors are used for measuring exposed structures on a substrate (either in resist and/or after etch). A fast and non-invasive form of specialized inspection tool is a scatterometer in which a beam of radiation is directed onto a target on the surface of the substrate and properties of the scattered or reflected beam are measured. Examples of known scatterometers include angle-resolved scatterometers of the type described in US2006033921A1 and US2010201963A1. In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

In some metrology applications, such as in some scatterometers or alignment sensors, imperfections in metrology targets can result in a wavelength/polarization dependent variation in a measured value from that target. As such, correction and/or mitigation for this variation is sometimes effected by performing the same measurement using multiple different wavelengths and/or polarizations (or more generally, multiple different illumination conditions). However, different wavelengths will diffract to different angles, complicating detection of the diffracted radiation which carries the wanted signal.

It would be desirable to improve detection of diffracted radiation at different wavelengths.

<u>SUMMARY OF THE INVENTION</u>

The invention in a first aspect provides an illumination module for a metrology device comprising: a configurable illumination module operable to provide measurement illumination over a configurable range of illumination angles; a grating light valve module for controllably configuring a spectral configuration of said measurement illumination; and a controller operable to control said configurable illumination module and said grating light valve module such that said spectral configuration of said measurement illumination is varied in dependence with illumination angle within said range of illumination angles so as to obtain a desired detection condition for detection of diffracted radiation from a diffractive structure resultant from a measurement of the diffractive structure using said measurement illumination.

The invention in a second aspect provides an illumination module for a metrology device comprising: a beam steering device for scanning a beam of said measurement illumination over said range of illumination angles during a measurement so as to provide measurement illumination over a configurable range of illumination angles; a color selection module for controllably configuring a spectral configuration of said measurement illumination; and a controller operable to control said beam steering device and said color selection module such that said spectral configuration of said measurement illumination is varied in dependence with illumination angle within said range of illumination angles so as to obtain a desired detection condition for detection of diffracted radiation from a diffractive structure resultant from a measurement of the diffractive structure using said measurement illumination.

The invention in a third aspect provides a method of measuring a diffractive structure with measurement illumination selectively comprising a plurality of desired wavelengths, the method comprising: scanning a beam of said measurement illumination over a range of illumination angles corresponding to a fully filled detection numerical aperture for each of the plurality of desired wavelengths so as to illuminate said diffractive structure; and during said scanning, for each illumination angle within said range of illumination angles, selecting all wavelengths of said plurality of desired wavelengths for which wanted diffracted order radiation, diffracted by said diffractive structure, will be captured within said detection numerical aperture.

The invention in a fourth aspect provides a method of measuring a diffractive structure with measurement illumination, the method comprising: scanning a beam of said measurement illumination over a range of illumination angles so as to illuminate said diffractive structure; and during said scanning, for each illumination angle within said range of illumination angles, selecting only combinations of a spectral configuration of the measurement beam and illumination angle of the measurement beam that are associated with a respective parameter of interest sensitivity value having the same sign.

Also disclosed is a metrology apparatus comprising a metrology device comprising the illumination module of the first or second aspect..

The above and other aspects of the invention will be understood from a consideration of the examples described below.

BRIEF DESCRIPTION OF THE DRAWINGS

Embodiments of the invention will now be described, by way of example only, with reference to the accompanying drawings, in which:

Figure 1 depicts a lithographic apparatus;

Figure 2 depicts a schematic overview of a lithographic cell;

Figure 3 depicts a schematic representation of holistic lithography, representing a cooperation between three key technologies to optimize semiconductor manufacturing;

Figure 4 depicts a schematic overview of a scatterometry apparatus used as a metrology device, which may comprise a dark field digital holographic microscope according to embodiments of the invention;

Figure 5 comprises (a) a schematic diagram of a dark field scatterometer for use in measuring targets using a first pair of illumination apertures, (b) a detail of diffraction spectrum of a target grating for a given direction of illumination;

Figure 6 is a schematic illustration of a grating light valve, illustrating its basic operation in (a) a top view, (b) an end-on view in a first configuration and (c) an end-on view in a second configuration;

Figure 7 is a schematic illustration of the operating principle of a source selection module usable in concepts disclosed herein, showing (a) an input spectrum, (b) a top view of radiation incident on the grating light valve, (c) an end-on view of radiation incident on the grating light valve and (d) the resultant output spectrum;

Figure 8 is a schematic illustration of the operating principle of a programmable illumination module which scans a beam over a programmable range of angles and therefore over a programmable region of the illumination pupil plane, thereby defining a programmable illumination profile;

Figure 9 is a pupil plane representation of an objective lens of a metrology tool, illustrating a problem of diffracted radiation being diffracted at angles dependent on wavelength;

Figure 10(a), 10(b) and 10(c) each show an illumination module scanning a beam at respective different angles, with a color selection module selecting an appropriate wavelength depending on the scanning angle in accordance with an embodiment;

Figure 11 is a pupil plane representation of an objective lens of a metrology tool, illustrating a result of the operating principle described by Figure 10(a), 10(b) and 10(c), where the diffracted radiation of different wavelengths are all diffracted to the same angles;

Figure 12 is a pupil plane representation of an objective lens of a metrology tool illustrating an additional embodiment, wherein a color selection module is of a programmable illumination module is controlled during a scan so as to prevent detection of diffraction orders higher than desired (e.g., first) diffraction orders;

Figure 13(a) shows a number of pupil plane sensitivity plots for respective different wavelengths illustrating a problem of very high overlay sensitivity variation with illumination angle leading to a very low average sensitivity in an image captured at a field plane aggregated over said angles;

Figure 13(b) shows a number of pupil plane sensitivity plots and color selection module control plots conceptually illustrating a method of addressing the problem described by Figure 13(b) according to an embodiment; and

Figure 14 is a block diagram that illustrates a computer system that may assist in implementing the methods and flows disclosed herein.

DETAILED DESCRIPTION OF EMBODIMENTS

Before describing embodiments of the invention in detail, it is instructive to present an example environment in which embodiments of the present invention may be implemented.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

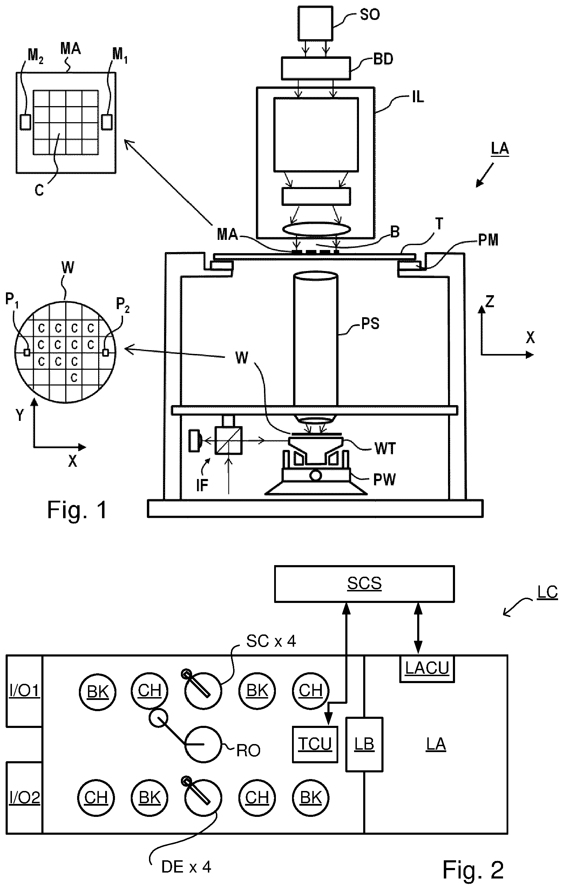

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

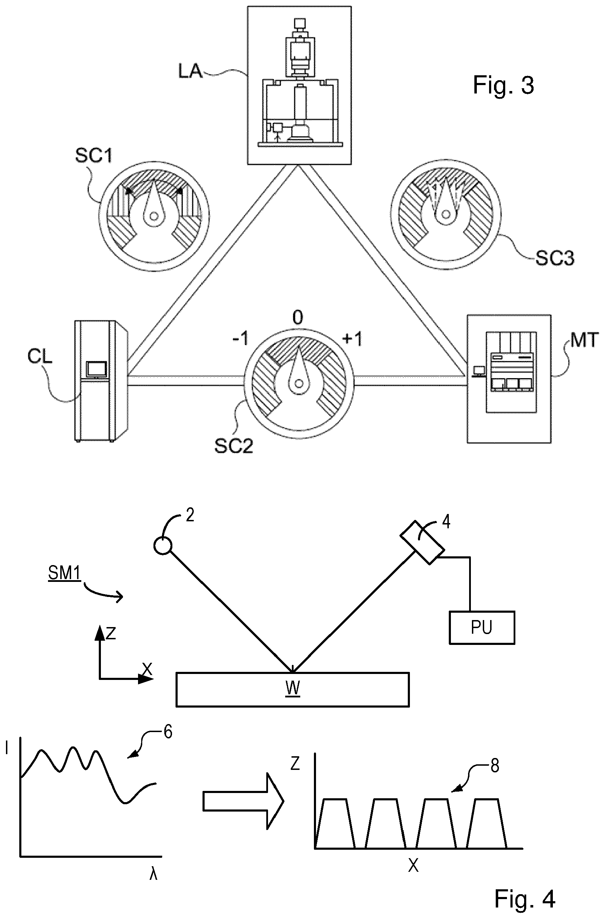

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

A metrology apparatus, such as a scatterometer, is depicted in Figure 4. It comprises a broadband (white light) radiation projector 2 which projects radiation onto a substrate W (optionally having been spectrally filtered to be narrowband prior to the substrate W) . The reflected or scattered radiation is passed to a spectrometer detector 4, which measures a spectrum 6 (i.e. a measurement of intensity as a function of wavelength) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Overall measurement quality of a lithographic parameter via measurement of a metrology target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

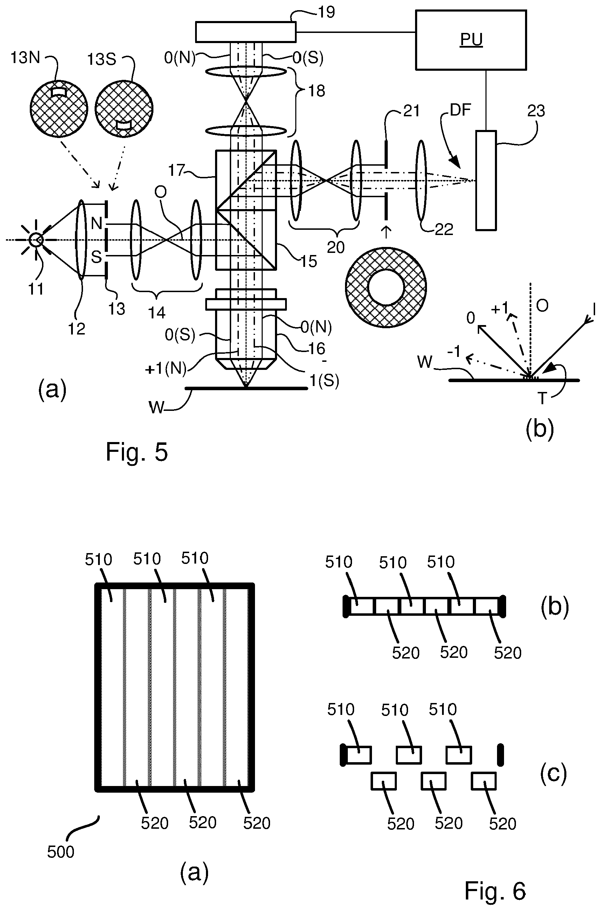

Another type of metrology apparatus is shown in Figure 5(a). A target T and diffracted rays of measurement radiation used to illuminate the target are illustrated in more detail in Figure 5(b). The metrology apparatus illustrated is of a type known as a dark field metrology apparatus. The metrology apparatus depicted here is purely exemplary, to provide an explanation of dark field metrology. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In other examples, a two quadrant aperture may be used. This may enable simultaneous detection of plus and minus orders, as described in US2010201963A1, mentioned above. Embodiments with optical wedges (segmented prisms or other suitable elements) in the detection branch can be used to separate the orders for imaging spatially in a single image, as described in US2011102753A1, mentioned above. In yet other embodiments, 2nd, 3rd and higher order beams (not shown in Figure 5) can be used in measurements, instead of or in addition to the first order beams. In yet other embodiments, a segmented prism can be used in place of aperture stop 21, enabling both +1 and -1 orders to be captured simultaneously at spatially separate locations on image sensor 23.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented.

A light source for metrology applications usable for concepts disclosed herein may comprise any broadband source and a color selection arrangement to select one or more colors from the broadband output. By way of an example, the radiation source may be based on a hollow core or solid core fiber such as a hollow core photonic crystal fiber (HC-PCF) or solid core photonic crystal fiber (SC-PCF). For example, in the case of a HC-PCF, the hollow core of the fiber may be filled with a gas acting as a broadening medium for broadening input radiation. Such a fiber and gas arrangement may be used to create a supercontinuum radiation source. Radiation input to the fiber may be electromagnetic radiation, for example radiation in one or more of the infrared, visible, UV, and extreme UV spectra. The output radiation may consist of or comprise broadband radiation, which may be referred to herein as white light. This is only one example of a broadband light source technology usable in methods and apparatuses disclosed herein, and other suitable technologies may instead be employed.

When using metrology sensors, including those described above and/or other types of metrology sensors (e.g., alignment sensors, levelling sensors), it is often desirable to control the illumination spectrum, e.g., to switch the illumination between different wavelengths (colors) and/or wavefront profiles.

To perform color selection, a color selection module has been proposed which uses grating light valve (GLV) technology such as marketed by Silicon Light Machines (SLM), e.g., as described in US6947613B, incorporated herein by reference. A GLV is an electrically-programmable diffraction grating based on Micro-Electro-Mechanical Systems (MEMS) technology. Figure 6 illustrates the principal. Figure 6 is a schematic illustration of a GLV pixel or component 500 from (a) above and (b), (c) end-on. The GLV component comprises alternating GLV reflective ribbons of two types: static or bias ribbons 510 which are typically grounded along with a common electrode and driven or active ribbons 520 which are driven by an electronic driver channel. A GLV module may comprise any number of these GLV components 500 arranged in an array. The active and bias ribbons may be essentially identical other than in how they are driven. When no voltage is applied to the active ribbons 520, they are co-planar with the bias ribbons, a configuration illustrated in Figure 6(b). In this configuration, the GLV acts essentially as a mirror, with incident light being specularly reflected. When a voltage is applied to the active ribbons 520, as illustrated in Figure 6(c), they deflect relative to the bias ribbons 510, establishing a square-well diffraction grating. In this state, incident light is diffracted into fixed diffraction angles. The ratio of light reflected with respect to light diffracted can be continuously varied by controlling the voltage on the active ribbons 520, which controls the magnitude of their deflection. As such, the amount of light diffracted by the GLV can be controlled in an analog fashion from zero (full specular reflection) to all incident light (zero specular reflection).

The GLV module may be used in a zeroth order mode such that the diffracted radiation is blocked/dumped and the specularly reflected (zeroth order) radiation is provided to the metrology tool. This has the advantage of preserving etendue.

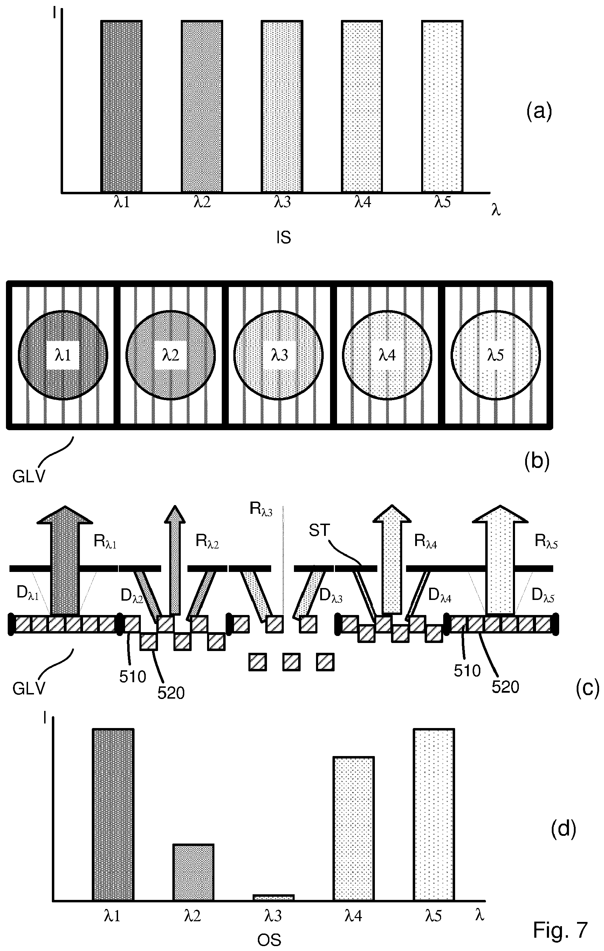

Figure 7 is a schematic illustration which explains conceptually how a GLV based source selection module may operate. Figure 7(a) is a plot of intensity I against wavelength $\lambda$ showing an exemplary input spectrum IP describing the dispersed broadband radiation from the broadband radiation source SO. In this example, the broadband radiation comprises five color bands $\lambda 1$ to $\lambda 5$ of equal intensity. Of course, this is only an illustrative example and there may be more or fewer color bands in the input spectrum, the input spectrum may be continuous across a wavelength range and/or there may be some intensity variation between colors. Similarly, the GLV module may be operable to selectively attenuate more or fewer wavelength bands than the five shown here.

Figure 7(b) shows each of these color bands on a respective portion of GLV module (shown looking down on the GLV ribbons). The illustrative drawing shows a color band per GLV component, although each color band may be incident on respective multiple GLV components (i.e., a plurality of GLV components are used to control each color). The plane defined by the GLV surface (e.g., the plane defined by the static ribbons) comprises a spectrally dispersed image plane of the system.

Figure 7(c) conceptually illustrates how the GLV is used to modulate the input spectrum IS. In the specific example shown, the GLV module portions on which colors $\lambda 1$ and $\lambda 5$ are incident are fully reflective (i.e., there is no voltage applied to, and therefore no displacement of, the active ribbons 520 such that they are coplanar with the static ribbons 510). The width of arrows $R_{\lambda 1}$, $R_{\lambda 5}$ represent the amount of light of colors $\lambda 1$, $\lambda 5$ which is reflected. The dotted lines $D_{\lambda 1}$, $D_{\lambda 5}$ represent the negligible or zero light diffracted into higher (non-zero) diffraction orders by the GLV. For colors $\lambda 2$, $\lambda 3$, $\lambda 4$, the active ribbons 520 are displaced by different amounts with respect to static ribbons 510 forming diffraction grating with respective different diffraction efficiencies. Once again the width of arrows $R_{\lambda 2}$, $P_{\lambda 3}$, $R_{\lambda 4}$ represent the amount of light of colors $\lambda 2$, $\lambda 3$ and $\lambda 4$ which is reflected and the size of blocks labeled $D_{\lambda 2}$, $D_{\lambda 3}$, $D_{\lambda 4}$ represent the amount of light of colors $\lambda 2$, $\lambda 3$ and $\lambda 4$ which his diffracted into higher (non-zero) diffraction orders by the GLV. All the diffracted light $D_{\lambda 2}$, $D_{\lambda 3}$, $D_{\lambda 4}$ (and $D_{\lambda 1}$, $D_{\lambda 5}$ if not entirely zero) is blocked by a stop ST or higher order block, such that only reflected radiation $R_{\lambda 1}$, $R_{\lambda 2}$, $R_{\lambda 3}$, $R_{\lambda 4}$ $R_{\lambda 5}$ is transmitted to the metrology device.

The stop ST may be located in a pupil plane of the system. The GLV module induces dispersion for all orders other than the zeroth order, leaving the zeroth order unaffected (the zeroth order etendue is not increased for example). This higher order dispersion results in a different beam position at the stop ST, allowing it to be blocked. Since the zeroth order is unaffected, the output beam will remain a (close to) Gaussian/single mode beam. This is particularly desirable for alignment applications (i.e., use in alignment sensors) as such alignment applications typically require a Gaussian or single mode beam.

Figure 7(d) is a plot of intensity I against wavelength $\lambda$ showing the resultant output spectrum OP based on the configuration of the GLV module illustrated in Figure 7(c). As can be seen, each spectral component $\lambda 1$, $\lambda 2$, $\lambda 3$, $\lambda 4$, $\lambda 5$

has an intensity I corresponding to the GLV configuration of the respective portion of the GLV module for that color. In this way, the intensity of each spectral component can be varied continuously between a minimum and maximum transmission. The minimum transmission may be less than 10%, less than 5%, less than 3%, less than 2%, less than 1%, less than 0.5% or less than 0.1%, for example. The maximum transmission may be more than 90%, more than 95%, more than 97%, more than 98%, more than 99%, more than 99.5% or more than 99.9%, for example. In this way, it is possible to configure a specific spectral profile for any measurement, improving measurement accuracy.

A GLV-based color selection module is an example of a type of color selection module which may be used in any suitable metrology device. Other fast-switching color section arrangements may also be used instead of a GLV, such as other light valve technologies, or more generally other spatial light modulation devices (e.g., acousto-optical modulation devices such as an acousto-optical tunable filter, digital micromirror device (DMD) technologies and/or LCOS (Liquid Crystal on Silicon) devices.

The concepts described below are described largely in context of using a GLV based color selection module, although the disclosure is not necessarily limited to such a color selection technology (at least in some aspects).

A number of illumination and detection concepts will now be described, which may be combined with the abovementioned color selection module in an illumination (or combined illumination and detection) strategy.

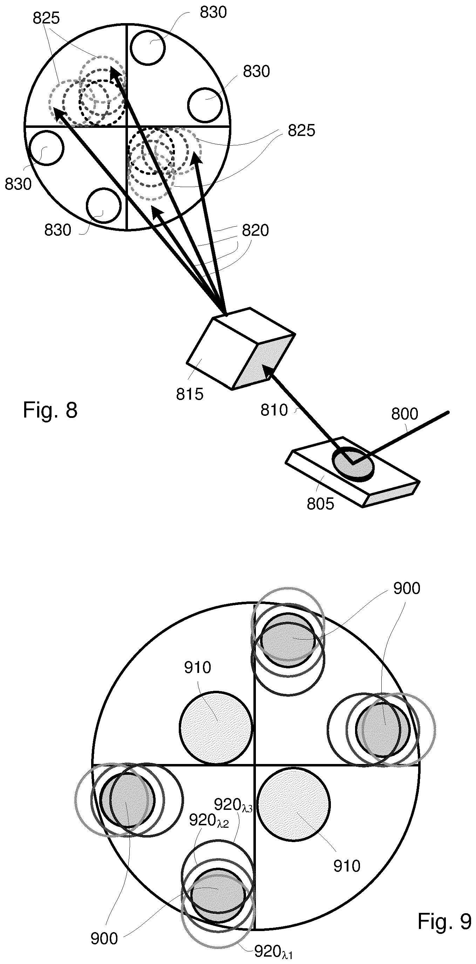

Figure 8 is a simplified schematic illustration of a proposed quickly programmable illumination. An input beam 800 is incident on a beam steering device 805 such as a fast Micro-electromechanical systems (MEMS) tiltable mirror. The steered beam 810 may be split into four copies 820 of the original beam using, for example a beam splitting optic or beam copying optic 815 or kaleidoscope optic. In this manner, by controlling the beam steering device 805, the beams 825 are very quickly steered or scanned over a configurable or programmable range of illumination angles and therefore illumination regions in an illumination pupil plane. The scanning may be sufficiently fast with respect to a measurement duration such that the scanned illumination within the illumination region is integrated over the measurement time. The scanning time over a typical desired range of illumination angles of the beam steering device or MEMS mirror 815 may be less than 1ms or less than 0.5ms for example. The illumination regions 825 are shown dotted in different positions relating to different illumination colors (the grayscale dotted lines being representative of different colors). These different positions comprise the illumination pupil regions for each respective wavelength (for a given detection pitch) corresponding to proper detection (e.g., a desired detection condition) at the detection apertures 830 (which may be at a fixed position for example). Depending on the wavelength of the illumination beam, the beam steering device 815 may be controlled to scan the beam over the appropriate illumination region for that wavelength.

While in many arrangements, the detection pupil or detection regions may be fixed, another proposal may use switchable detection. This can be achieved in different ways, such as by placing a device similar to an Illumination Mode Selector (IMS) in the detection path. An IMS is a known illumination selection method in which different fixed apertures are arranged on an aperture wheel such that they can be selectively switched or rotated into the illumination beam path as required. In a similar manner, a chosen detection aperture (and/or wedge) can be switched into the detected radiation depending on application. A detection aperture or sub-aperture (detection region) may also be shifted in the pupil-plane to accommodate a change in wavelength/pitch (in combination with or separate from the illumination).

For a number of measurement applications, such as those which are based on incoherent imaging techniques, it may be desirable or required to overfill the detection regions (detection mask or detection numerical aperture NA), i.e., such that at least the entire detection region is substantially filled with the detected (diffracted) radiation. In the context of this disclosure, "substantially filled" may describe the entire detection region being over 80% filled, over 85% filled, over 90% filled, over 95% filled, over 98% filled, over 99% filled, over 99.5% filled or 100% filled. This may enable simpler computational corrections and/or reduce cross-talk. By contrast, a partial filling of the detection mask will result in (partial) incoherent imaging which will increase sensitivity to cross-talk.

Because of this, it is typical to provide a configurable illumination profile (e.g., using an IMS or a programmable illuminator such as illustrated in Figure 8) to select or configure the illumination profile based on wavelength and target pitch so as to obtain a substantially filled or overfilled detection pupil. The configurable illumination profile may also be configured to prevent second order diffracted light leaking into the detection pupil. Present methods for achieving this are satisfactory when a single illumination wavelength is used. However, when measuring with multiple wavelengths in parallel, a selected mechanical aperture or programmed illumination mask will be suboptimal (a sub-optimal illumination NA) for each, or all but one, wavelength. As a result, the detection mask may be not completely (or substantially) filled for one or more of the wavelengths. Because of this, a mechanical operation in the IMS may be performed to switch between apertures when performing a multi-wavelength measurement on a single target. However, in such case, the illumination pupil is not always efficiently used due to the limited available (e.g., quad-) apertures.

Figure 9 illustrates the issue of configuring the illumination when using multiple wavelengths in parallel. It shows a pupil plane representation (e.g., of an objective lens of a metrology device) divided into an illumination pupil (top left and bottom right quadrants) and a detection pupil (top right and bottom left quadrants); the order of these quadrants is arbitrary, and the pupil plane may be divided between illumination and detection regions in any suitable manner. It is desirable to overfill the fixed detection regions or detection mask 900 (shaded) with the detected illumination. The illumination regions or illumination mask 910 is configured such that this is achieved for one of the illumination wavelengths $\lambda 2$, as indicated by detected illumination position $920_{\lambda 2}$ for this wavelength. However, the detection regions 900 are only partially filled for the two other wavelengths $\lambda 1$, $\lambda 3$ present in the illumination used in this example, as indicated by respective detected illumination positions $920_{\lambda 1}$, $920_{\lambda 3}$. When multiple wavelengths are being selected simultaneously, for example by a GLV, this can result in partially filled detection for certain wavelengths. This is undesirable and should be avoided as has been explained.

A proposed method and illumination module is provided which synchronizes the wavelength selection (spectral configurations of the illumination) with a programmable or configurable range of illumination angles and/or detection angles such that only wavelengths are selected at any time which result in proper detection (i.e., for a particular structure pitch of a diffractive structure being measured) or desired detection condition. The module may comprise: a grating light valve module (or other color selection module such as a fast-switching MEMS or other light valve color selection module) for controllably configuring a spectral configuration (e.g., a wavelength, combination or weighted combination of wavelengths) of said measurement illumination, a configurable illumination module operable to provide measurement illumination over a configurable range of illumination angles and a controller for controlling the configurable illumination module and grating light valve module.

The configurable illumination module may comprise a beam steering device, e.g., which scans a beam over the illumination pupil (e.g., over a range of illumination angles) sufficiently fast to define a desired range of illumination angles or illumination shape in a pupil plane. In an embodiment, such a module may comprise both of a beam scanning device, a GLV module and a controller, the controller configured to scan over a range of illumination angles while controlling the GLV module to select wavelengths (single wavelengths or combinations of multiple wavelengths) which will be properly detected by the detection mask (within the detection NA), the colors being selected in dependence on the illumination angle (beam position in the illumination pupil) during scanning. Properly detected (i.e., the desired detection condition) in this context may comprise maintaining the detection regions (detection NA) to be overfilled. Overfilled in this context may mean being substantially filled (e.g., as defined above) with detected radiation or diffracted order radiation resulting from the scanned illumination being diffracted by a target or other diffractive structure for each of a plurality of desired wavelengths. Alternatively or in addition, Properly detected may mean that the diffracted radiation of a plurality of desired wavelengths are detected in a substantially common region in the detection pupil plane.

The detection mask/detection NA may be fixed, or it may be configurable/movable such that the GLV color selection is synchronized with the illumination beam position and/or detection mask position.

A GLV can have a switching speed of a few $\mu s$, which is much faster than the scanning speed of a MEMS mirror (e.g., 0.5-1ms) which may be used for scanning the illumination over the illumination region. As such, if the scanning of the MEMS mirror over an illumination region takes 1ms or more, the GLV module can switch colors on and off about 50-100 times during a single scan. This may comprise switching colors individually and/or switching multiple colors simultaneously, and may further optionally comprise a non-binary control of each wavelength such that intensity of individual wavelengths may be attenuated by less than 100% (e.g., attenuation at multiple values or continuously between 0% and 100%).

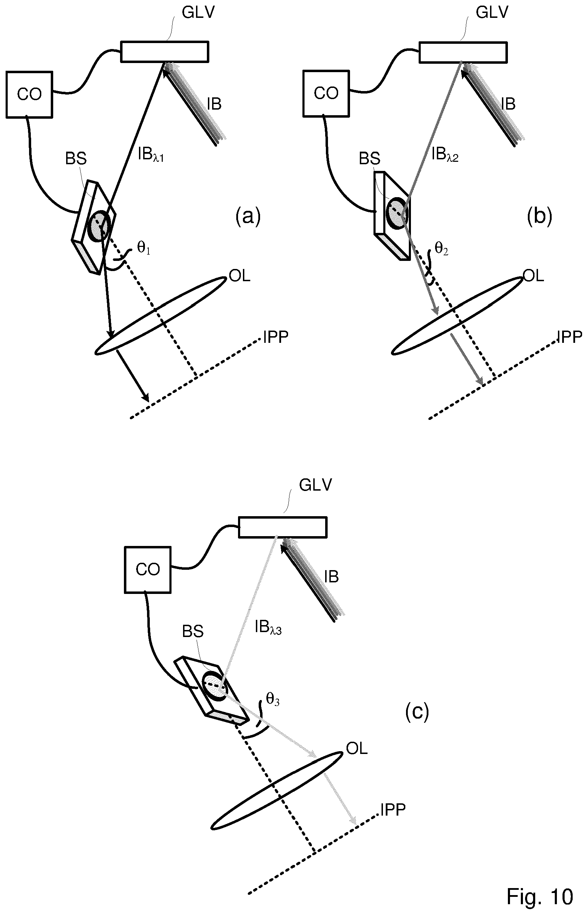

Figure 10 schematically illustrates the principle. Figure 10(a) shows a first instant or snapshot during a scan through a range of illumination angles, at a point where the beam steering element BS is steering the beam $IB_{\lambda 1}$ through a first angle $\theta_1$, and therefore a first position in the illumination pupil plane IPP of objective lens OL. Based on this angle (and target pitch), the controller CO controls the GLV module, which receives a broadband illumination beam IB, to select an appropriate one or more wavelengths for illumination beam $IB_{\lambda 1}$. Figure 10(b) shows a second instant during the same scan where the beam steering element BS is steering the beam $IB_{\lambda 2}$ through a second angle $\theta_2$ and therefore a second position in the illumination pupil plane IPP. Based on this angle (and target pitch), the controller CO controls the GLV module to select an appropriate one or more wavelengths for illumination beam $IB_{\lambda 2}$. Similarly, Figure 10(c) shows a third instant during the scan where the beam steering element BS is steering the beam $IB_{\lambda 3}$ through a third angle $\theta_3$ and therefore a third position in the illumination pupil plane IPP. Based on this angle (and target pitch), the controller CO controls the GLV module to select an appropriate one or more wavelengths for illumination beam $IB_{\lambda 3}$.

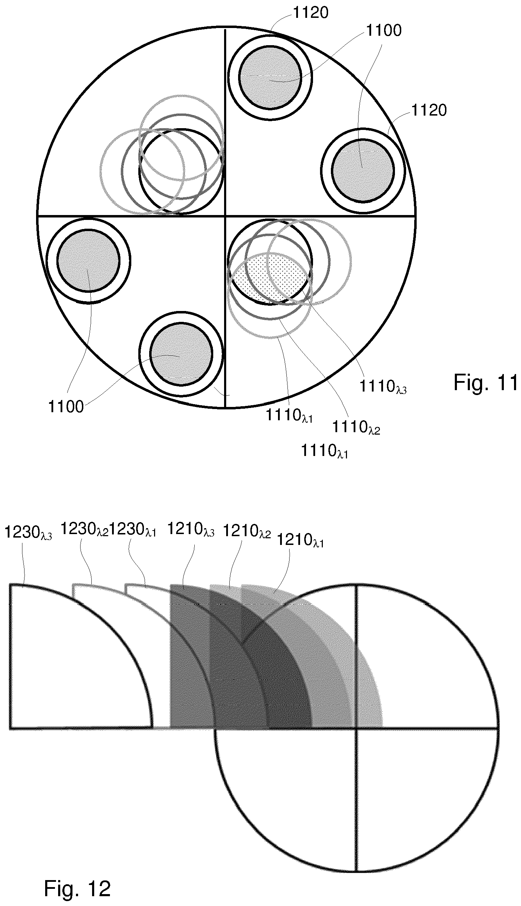

Figure 11 shows an example pupil plane representation where (for a given target pitch) an illumination NA or range of angles through an illumination scan and the spectral configurations of the scanned beam are controlled together in relation to a (fixed) detection NA 1100 to ensure overfilled detection of the detection NA for all desired wavelengths of the measurement. In Figure 11, the illumination areas $1110_{\lambda 1}$, $1110_{\lambda 2}$, $1110_{\lambda 3}$ for three wavelengths $\lambda 1$, $\lambda 2$, $\lambda 3$ are shown (only labeled for one of the four beams- it should be appreciated that the concepts disclosed are also applicable for to two beam measurements, e.g., only for x or y targets, and/or single beam measurements) which result in an overfilled detection NA by wanted diffracted order radiation 1120 (e.g., first diffraction order radiation) for each wavelength $\lambda 1$, $\lambda 2$, $\lambda 3$. In this way, the wanted diffracted order radiation 1120 will be in the same pupil plane position for each wavelength. These illumination areas $1110_{\lambda 1}$, $1110_{\lambda 2}$, $1110_{\lambda 3}$ areas can be determined for all required wavelengths (e.g., by calculation using well-known diffraction laws or observation). The scanning of the illumination may cover the entire extent of the illumination areas $1110_{\lambda 1}$, $1110_{\lambda 2}$, $1110_{\lambda 3}$, while per pixel-position, an appropriate relevant one or more wavelengths are selected.

As such, for each respective illumination regions corresponding to a particular used wavelength or wavelength of interest, the GLV module (or other color selection module) may be controlled to always select the wavelength corresponding to the illumination region being scanned. Where these illumination regions overlap, the two or more wavelengths corresponding to the overlapping illumination regions should be selected.

For example, should it be decided to measure a particular target with a combination of three wavelengths $\lambda 1$, $\lambda 2$, $\lambda 3$, the GLV module may be controlled during an illumination scan to select all three of these wavelengths when scanning in the illumination plane regions where all three illumination areas $1110_{\lambda 1}$, $1110_{\lambda 2}$, $1110_{\lambda 3}$ overlap in the illumination pupil plane. This region is shown shaded for the beam corresponding to the labeled illumination areas $1110_{\lambda 1}$, $1110_{\lambda 2}$, $1110_{\lambda 3}$. Similarly when scanning in the illumination plane regions where two of the three illumination areas $1110_{\lambda 1}$, $1110_{\lambda 2}$, $1110_{\lambda 3}$ overlap, only these two wavelengths should be switched on via the GLV module, and for regions where an illumination area does not overlap another, only the wavelength corresponding to this illumination area should be switched on. In this manner, the detection regions 1100 should be overfilled for each wavelength.

As an alternative to using a scanned beam and beams steering device as described, a discrete switching of illumination angles (e.g., implemented via an IMS), where per selected illumination aperture a different spectrum is provided by the GLV.

The range of detection angles defined by said detection mask/NA may be fixed. In an optional refinement, for certain detection aperture masks it might also be possible/beneficial to shift the detection aperture mask together with the illumination aperture mask, for example to achieve Littrow conditions.

Figure 11 relates to an illumination solution for a proposed incoherent detection method, for example which may use computational imaging techniques to correct for measurement aberrations resultant from simplified optics. However, the methods disclosed herein may be also used with presently used illumination modes, e.g., using quadrant illumination such as presently used in micro-diffraction based overlay ($\mu$DBO) or focus ($\mu$DBF) techniques.

Figure 12 illustrates a method for controlling the spectral configurations of a scanned beam being used to define a quadrant illumination profile, such a profile presently being used in many metrology techniques, for a single quadrant and single direction, to ensure capture of the first diffraction order per wavelength, but no higher orders. The solid pupil regions $1210_{\lambda 1}$, $1210_{\lambda 2}$, $1210_{\lambda 3}$ show the positions of wanted diffraction order radiation i.e., first diffraction orders per wavelength $\lambda 1$, $\lambda 2$, $\lambda 3$ as captured in the pupil plane, with respect to a detection pupil (top-left quadrant in this Figure) resultant from single quadrant illumination comprising three wavelengths $\lambda 1$, $\lambda 2$, $\lambda 3$. The unfilled pupil regions $1230_{\lambda 1}$, $1230_{\lambda 2}$, $1230_{\lambda 3}$ show the positions of unwanted diffraction order radiation, i.e., unwanted second diffraction orders per wavelength $\lambda 1$, $\lambda 2$, $\lambda 3$ as captured in the pupil plane, with respect to the detection pupil. During scanning of the illumination angles which map to the unwanted second orders that are captured within the detection pupil, the spectral configuration of the beam can be controlled to switch off wavelengths (e.g., switch them off via the GLV module) which would otherwise result in the unwanted captured second orders.

By way of specific example, when scanning the illumination region corresponding to the second order diffraction region $1230_{\lambda 1}$, within the detection pupil, the corresponding wavelength $\lambda 1$ can be switched off. This should be performed for both illumination quadrants for both directions, where applicable. It may be appreciated that this is a quite different application of the concepts disclosed herein as ensuring overfilled detection is not important for such embodiments (the imaging regime may be partly-incoherent in such embodiments). In this case, proper detection of the detected radiation (the desired detection condition) may be understood to mean detection of only wanted orders (e.g., first diffraction orders but no higher order radiation).

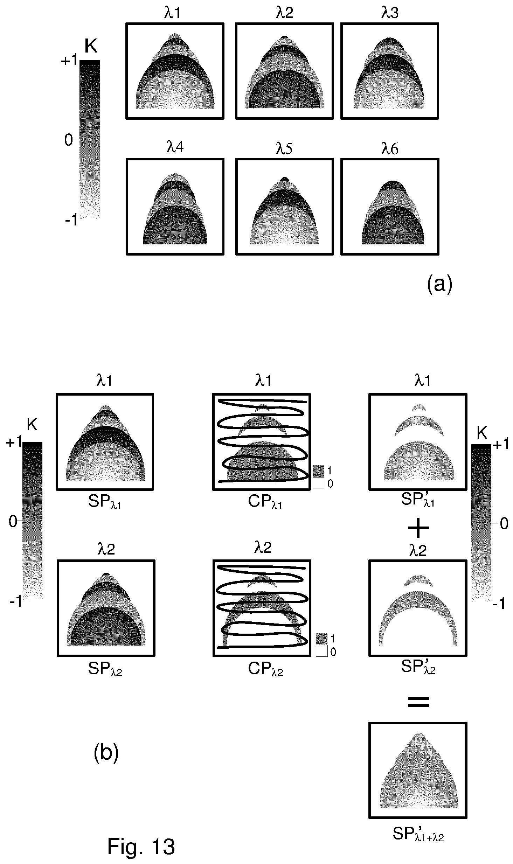

Another application of the concepts disclosed herein will be described with reference to Figure 13. In many metrology applications, and in particular overlay metrology applications, measurement performance is strongly dependent on a number of illumination parameters such as: wavelength, polarization, angle and phase of the illumination beam. In many present metrology tools, there is no hardware provision for control of angle or phase; wavelength and/or polarization can be selected for all angles universally but not per angle. The lack of angle-based parameter control can lead to non-ideal metrology (e.g., overlay) performance in certain use cases.

For example, and in particular for relatively thick stacks (e.g., thicker than 1.5$\mu$m or thicker than 2$\mu$m), the wavelength and angle dependence of overlay sensitivity (K) becomes stronger and therefore proper selection of wavelength and angle becomes more important. In an example shown in Fig. 13(a), the calculated overlay sensitivity K of a target (e.g., here an x-direction target) is represented in grayscale as a function of the pixel position in the exit pupil plane (of the objective lens of a metrology tool) for 6 different, closely spaced, wavelengths $\lambda 1$-$\lambda 6$. In this specific example, the wavelengths may be spaced apart by 20nm between $\lambda 1$=600nm and $\lambda 6$=700nm (e.g., $\lambda 2$=620nm, $\lambda 3$=640nm etc.). This spacing will actually be dependent on the stack thickness as will be described. As such, each plot comprises a sensitivity map resolved in a pupil plane. More generally, each plot comprises parameter of interest sensitivity data.

Due to the large stack thickness and the interferometric effect inherent in diffraction based overlay methods, the K value varies strongly in the pupil plane such that it comprises alternating positive values (darker regions) and negative values (lighter regions) in ring-shaped zones for each of these (and all other) wavelengths. In particular, the position or "phase" of the overlay sensitivity K variation in the ring-shaped zones changes as a function of stack thickness. The term phase describes the fact that these alternating regions may actually represent an oscillation of the sensitivity between positive and negative values over the pupil plane. Because of this, between different measurement locations on a wafer, there can be very significant changes of K for a given pixel position. In μDBO measurement, a single intensity value is measured per target/sub-target in a field plane image and therefore all the K values in the detection area of the pupil plane are summed into one K value in the field plane. As a result, the positive and negative K values at different pupil positions (angles) cancel each other, leading to a near-zero mean overlay sensitivity K value in detected μOPB image (i.e., the image is largely insensitive to overlay).

In this embodiment, it is proposed to vary the wavelength (e.g., via the GLV or other color selection module) during scanning of the illumination through the pupil plane (through angles of the illumination NA so as to ensure a good average overlay (or other parameter of interest) sensitivity K magnitude (e.g., an overlay sensitivity K magnitude above a threshold such as 0.3, 0.4, 0.5, 0.6, 0.7 or 0.8 on a magnitude scale between 0 and 1). An "angle of illumination NA" or "illumination angle" may be understood to encompass or describe a coordinate in a pupil plane expressable in terms of a combination of polar angle and azimuthal angle).

This may be achieved by only using combinations of the spectral configuration and illumination angle of the measurement beam which maximize said average parameter of interest sensitivity value. This may be further achieved by selecting a wavelength (or combination of wavelengths) and scanning this wavelength over regions of the pupil plane corresponding to only one sign for parameter of interest sensitivity. Note that theoretically the actual sensitivity value K does not have a limited scale. The values here refer to a normalized scale (between 0 to 1) based on the absolute maximum K as present in the resulting pupil response.

In an embodiment, such a method may comprise switching between two (or more) wavelengths (or two or more combinations of wavelengths) during portions of the scan such that the sign of the overlay sensitivity K does not change over the scan (e.g., it is always maintained positive or negative, it does not matter which).

Referring again to Figure 13(a), it can be appreciated that certain pairs of wavelengths (or pairs of wavelength combinations) result in respective overlay sensitivity maps which are complementary; i.e., where positive sensitivity regions in a sensitivity plot for a first of the determined wavelengths largely correspond in terms of pupil position with negative sensitivity regions in a sensitivity plot for a second of the determined wavelengths.

Figure 13(b) conceptually illustrates a proposed method which exploits this. Two wavelengths (or wavelength combinations) are determined which have complementary overlay sensitivity maps (more generally complementary respective parameter of interest sensitivity data) as described; these wavelengths may be determined mathematically. Once the wavelengths have been determined, a respective sensitivity map may be predicted based on known stack parameters, and in particular the stack thickness (grating separation). Alternatively, the sensitivity maps may be measured.

In Figure 13(b) the two wavelengths chosen are $\lambda1$ and $\lambda2$. To understand the method conceptually, first consider the wavelength $\lambda1$. Shown is the corresponding sensitivity plot $SP_{\lambda1}$ for this wavelength. A color selection control plot $CP_{\lambda1}$ shows the regions for which this color may be switched on (dark shading) and off (no shading) during an illumination scan over the pupil plane (e.g., as may be implemented via a beam steering device and color selection module such as a GLV module as has been described). The actual scan would of course be much finer than the very coarse path shown for illustration. As may be observed in the drawing, the regions for which wavelength $\lambda1$ is switched on correspond to regions of the sensitivity plot $SP_{\lambda1}$ corresponding to a common sign for the sensitivity (i.e., all positive or all negative). In this specific example, negative sign regions are selected. The result is a tailored or configured sensitivity map $SP_{\lambda1}'$. The same situation is shown for wavelength $\lambda2$, which shows equivalent sensitivity plot $SP_{\lambda2}$ for this wavelength. It can be observed from the color selection control plot $CP_{\lambda2}$ that regions of the pupil plane for which this wavelength $\lambda2$ is switched on correspond to regions of the sensitivity plot $SP_{\lambda2}$ for which the sensitivity has the same sign as the regions selected for the first wavelength. The result is a tailored or configured sensitivity map $SP_{\lambda2}'$.

Note that the selected areas from the two single-wavelength sensitivity plots may overlap to obtain the configured sensitivity map. For each wavelength, the areas having expected high sensitivity are selected, which can overlap.

In an actual embodiment, the color selection control signals represented by plots $CP_{\lambda1}$ and $CP_{\lambda2}$ are implemented within a single scan through the pupil plane, such that the illumination switches between the two wavelengths (or wavelength combinations) over a scan, to obtain a synthetized pupil having a sensitivity plot $SP'_{\lambda1+\lambda2}$ comprising substantially only negative (or substantially only positive) overlay sensitivity K values. In such an embodiment, comprising substantially only sensitivity values of one sign may describe comprising sensitivity values of one sign for over 70%, over 80%, over 90%, over 95% or over 99% of the scanned pupil region or scanned illumination angles (e.g., of pixels within the scanned region); i.e., of the configured illumination NA.

This concept of this method may be generalized by selecting wavelengths which have a similar expected phase of overlay sensitivity K, e.g. $\pm\pi/4$, for all pupil pixel-positions.

In metrology methods where all K values in the pupil plane are summed into one value in the field plane, such an approach will result in a much higher mean sensitivity K magnitude than for conventional methods illustrated by Figure 13(a) where positive and negative K values cancel each other leading to near-zero K in the field plane. As such, overlay performance will be improved.

For challenging cases it can still happen that for the chosen phase of K the response is close to zero due to (unknown) stack variations over the wafer. To counter this, three measurements at different phases of K can be used to ensure an extreme is always captured.

While the embodiment described uses two complementary wavelengths (i.e., having complementary pupil sensitivity plots), improvement over the prior art will be obtained using only a single wavelength switched on only when scanning regions corresponding to one sign for overlay sensitivity. For example, referring to Figure 13(b), either one of the configured sensitivity maps $SP_{\lambda1}$' or $SP_{\lambda2}$' will result in better performance (higher average sensitivity) than the sensitivity maps $SP_{\lambda1}$ or $SP_{\lambda2}$.

While this embodiment is described in relation to measuring thick stacks, the concepts are also applicable to thinner stacks and in-device metrology (IDM) techniques, where the pupil K variation would be less strong but still exists. For example, the pupil variation could also occur because of non-ideal grating shapes (side-wall angle, floor-tilt, etc.).

Figure 13(b) describes a binary wavelength control (ON or OFF). However, wavelength combinations may be used which are weighted depending on the illumination angle. Also, the spectral configurations may additionally comprise the polarization state of the illumination which can also be varied when scanning over the pupil.

The description above has describes increasing average signal strength, however the selective pupil sampling can also be used to adapt to (known) sensor-aberrations for which the impact over the pupil can be attenuated via the intensity of the wavelength.

In the example of Figure 13(b) the two wavelengths which provide K maps that are almost complementary to each other, i.e., such that the location of the positive K zones for wavelength $\lambda1$ are spatially complementary to those for wavelength $\lambda2$. The following estimation shows how to find such a pair of wavelengths for a given stack.

As is well known in diffraction based overlay metrology, in the presence of overlay *OV*, the intensity difference $\Delta I$ between the +1 and -1 diffraction orders is given by:

$$\Delta I = I_1 - I_{-1}$$
$$= 4AB \cdot sin\left(4\pi\frac{T}{\lambda \cdot \cos\theta}\right)sin\left(\frac{2\pi}{p}OV\right), \ldots\ldots(1)$$

where A and B describes the diffraction efficiency at the top grating and bottom grating, respectively; *p* is their pitch, *T* is the separation between the top and bottom gratings, $\theta$ is the incident angle, and $\lambda$ is the wavelength. When overlay *OV* is small:

$$\Delta I = \frac{8\pi AB}{p} sin\left(4\pi\frac{T}{\lambda \cdot \cos\theta}\right) \cdot OV = K \cdot OV, \ldots\ldots(2)$$

To maximize overlay sensitivity K, $\lambda2$ should give a different sign of K than that given by $\lambda1$ and the wavelength difference $\Delta\lambda$ ($\Delta\lambda = \lambda_2 - \lambda_1$) should be as small as possible, therefore:

$$4\pi\frac{T}{\lambda1 \cdot \cos\theta} + \pi = 4\pi\frac{T}{\lambda2 \cdot \cos\theta} = 4\pi\frac{T}{(\lambda1 + \Delta\lambda2) \cdot \cos\theta} \qquad (3)$$

Which gives:

$$\Delta\lambda = \frac{-\lambda1}{\frac{4T}{\lambda1 \cdot \cos\theta} + 1}, \ldots\ldots(4)$$

As such, Equation 4 may be used to determine a suitable wavelength pair as a pair of wavelengths separated by $\Delta\lambda$ as calculated according to the stack and measurement properties.

In this embodiment, the parameter of interest has been predominately described as being overlay. However, this is not the only parameter of interest to which these methods are applicable. Other such parameters of interest may include *inter alia:* critical dimension, side wall angle, process variation. Such parameters of interest can also induce (e.g.,

weaker yet obvious) KPI variations in the pupil that will benefit from the same concepts.

It can be appreciated that the methods just disclosed can also reduce the amount of stray light in the metrology tool. In the disclosed methodology, only those illumination angles represented by the shaded "1" regions over both plots $CP_{\lambda 1}$, $CP_{\lambda 2}$ is the illumination "on" and used for overlay detection, for the other angles the illumination is off. By contrast, in the present metrology techniques, the illumination angles outside of these regions are also on; these have no contribution to overlay but result in stray light within the tool.

In all the above examples and embodiments, the relative intensity of the individual wavelengths can be controlled/attenuated as via the GLV module using methods already described.

In all the above examples and embodiments, all the captured wavelengths may be captured in a single camera acquisition. Alternatively, should the illumination mask per wavelength be defined sufficiently quickly (e.g., via a single moving sub-aperture or a smaller spot with sufficiently fast mirrors), the wavelength-ranges can also be captured sequentially using a high frame-rate camera synchronized with the movement of the illumination sub-aperture shape per wavelength and the GLV module.

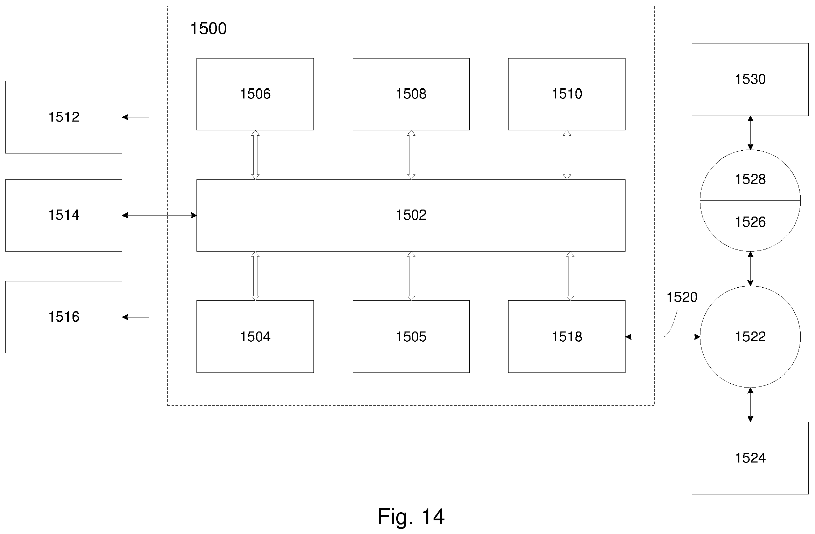

Figure 14 is a block diagram that illustrates a computer system 1500 that may assist in implementing the methods and flows disclosed herein. Computer system 1500 includes a bus 1502 or other communication mechanism for communicating information, and a processor 1504 (or multiple processors 1504 and 1505) coupled with bus 1502 for processing information. Computer system 1500 also includes a main memory 1506, such as a random access memory (RAM) or other dynamic storage device, coupled to bus 1502 for storing information and instructions to be executed by processor 1504. Main memory 1506 also may be used for storing temporary variables or other intermediate information during execution of instructions to be executed by processor 1504. Computer system 1500 further includes a read only memory (ROM) 1508 or other static storage device coupled to bus 1502 for storing static information and instructions for processor 1504. A storage device 1510, such as a magnetic disk or optical disk, is provided and coupled to bus 1502 for storing information and instructions.

Computer system 1500 may be coupled via bus 1502 to a display 1512, such as a cathode ray tube (CRT) or flat panel or touch panel display for displaying information to a computer user. An input device 1514, including alphanumeric and other keys, is coupled to bus 1502 for communicating information and command selections to processor 1504. Another type of user input device is cursor control 1516, such as a mouse, a trackball, or cursor direction keys for communicating direction information and command selections to processor 1504 and for controlling cursor movement on display 1512. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 1500 in response to processor 1504 executing one or more sequences of one or more instructions contained in main memory 1506. Such instructions may be read into main memory 1506 from another computer-readable medium, such as storage device 1510. Execution of the sequences of instructions contained in main memory 1506 causes processor 1504 to perform the process steps described herein. One or more processors in a multi-processing arrangement may also be employed to execute the sequences of instructions contained in main memory 1506. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 1504 for execution. Such a medium may take many forms, including but not limited to, non-volatile media, volatile media, and transmission media. Non-volatile media include, for example, optical or magnetic disks, such as storage device 1510. Volatile media include dynamic memory, such as main memory 1506. Transmission media include coaxial cables, copper wire and fiber optics, including the wires that comprise bus 1502. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 1504 for execution. For example, the instructions may initially be borne on a magnetic disk of a remote computer. The remote computer can load the instructions into its dynamic memory and send the instructions over a telephone line using a modem. A modem local to computer system 1500 can receive the data on the telephone line and use an infrared transmitter to convert the data to an infrared signal. An infrared detector coupled to bus 1502 can receive the data carried in the infrared signal and place the data on bus 1502. Bus 1502 carries the data to main memory 1506, from which processor 1504 retrieves and executes the instructions. The instructions received by main memory 1506 may optionally be stored on storage device 1510 either before or after execution by processor 1504.

Computer system 1500 also preferably includes a communication interface 1518 coupled to bus 1502. Communication interface 1518 provides a two-way data communication coupling to a network link 1520 that is connected to a local network 1522. For example, communication interface 1518 may be an integrated services digital network (ISDN) card or a modem to provide a data communication connection to a corresponding type of telephone line. As another example, communication interface 1518 may be a local area network (LAN) card to provide a data communication connection to a compatible LAN. Wireless links may also be implemented. In any such implementation, communication interface 1518 sends and receives electrical, electromagnetic or optical signals that carry digital data streams representing various types of information.

Network link 1520 typically provides data communication through one or more networks to other data devices. For example, network link 1520 may provide a connection through local network 1522 to a host computer 1524 or to data equipment operated by an Internet Service Provider (ISP) 1526. ISP 1526 in turn provides data communication services through the worldwide packet data communication network, now commonly referred to as the "Internet" 1528. Local network 1522 and Internet 1528 both use electrical, electromagnetic or optical signals that carry digital data streams. The signals through the various networks and the signals on network link 1520 and through communication interface 1518, which carry the digital data to and from computer system 1500, are exemplary forms of carrier waves transporting the information.

Computer system 1500 may send messages and receive data, including program code, through the network(s), network link 1520, and communication interface 1518. In the Internet example, a server 1530 might transmit a requested code for an application program through Internet 1528, ISP 1526, local network 1522 and communication interface 1518. One such downloaded application may provide for one or more of the techniques described herein, for example. The received code may be executed by processor 1504 as it is received, and/or stored in storage device 1510, or other non-volatile storage for later execution. In this manner, computer system 1500 may obtain application code in the form of a carrier wave.

Further embodiments are disclosed in the subsequent list of numbered clauses:

1. An illumination module for a metrology device comprising:

a configurable illumination module operable to provide measurement illumination over a configurable range of illumination angles;
a grating light valve module for controllably configuring a spectral configuration of said measurement illumination; and
a controller operable to control said configurable illumination module and said grating light valve module such that said spectral configuration of said measurement illumination is varied in dependence with illumination angle within said range of illumination angles so as to obtain a desired detection condition for detection of diffracted radiation from a diffractive structure resultant from a measurement of the diffractive structure using said measurement illumination.

2. An illumination module as defined in clause 1, wherein a desired detection condition comprises substantially filling a detection numerical aperture with wanted diffracted order radiation resulting from said measurement of the diffractive structure, for each of a plurality of desired wavelengths of said measurement illumination.

3. An illumination module as defined in clause 2, wherein the controller is operable to simultaneously:

control said configurable illumination module to provide measurement illumination over a range of illumination angles corresponding to a substantially filled detection numerical aperture for each of the plurality of desired wavelengths; and
control said grating light valve module to select, for each illumination angle within said range of illumination angles, all wavelengths of said plurality of desired wavelengths for which the wanted diffracted order radiation will be captured within said detection numerical aperture.

4. An illumination module as defined in clause 1, wherein a desired detection condition comprises, for each of a plurality of desired wavelengths of said measurement illumination, detecting within a detection numerical aperture only one or more wanted diffraction order radiation resulting from the measurement of the diffractive structure, and not detecting any unwanted diffraction order radiation resulting from the measurement of the diffractive structure.

5. An illumination module as defined in clause 4, wherein said unwanted diffraction order radiation comprises diffraction order radiation higher than a first diffraction order.

6. An illumination module as defined in any of clauses 2 to 5, wherein said wanted diffraction order radiation comprises one or more first diffraction orders.

7. An illumination module as defined in any preceding clause, wherein said configurable illumination module comprises a beam steering device for scanning a beam of said measurement illumination over said range of illumination angles during a measurement.

8. An illumination module as defined in clause 7, wherein said controller is operable to vary the spectral configuration of said measurement illumination during a single scan of said beam of said measurement illumination over said range of illumination angles in dependence with said with illumination angle.

9. An illumination module as defined in clause 8, wherein said desired detection condition comprises obtaining an average parameter of interest sensitivity magnitude for said measurement which is greater than 0.5 on a scale between 0 and 1.

10. An illumination module as defined in clause 9, wherein said parameter of interest is overlay.

11. An illumination module as defined in clause 9 or 10, wherein said controller is operable to control said configurable illumination module and said grating light valve module so as to select, for substantially each illumination angle of the range of illumination angles, only combinations of the spectral configuration and illumination angle of the measurement beam which maximize said average parameter of interest sensitivity value.

12. An illumination module as defined in any of clauses 9 to 11, wherein said controller is operable to control said configurable illumination module and said grating light valve module so as to select, for substantially each illumination angle of the range of illumination angles, only combinations of the spectral configuration and illumination angle of the measurement beam that are associated with a respective parameter of interest sensitivity value having the same sign.

13. An illumination module as defined in clause 12, wherein said controller is operable, during a single scan of said beam of said measurement illumination, to select a respective spectral configuration of one or more different spectral configurations at illumination angles which correspond to parameter of interest sensitivity values which substantially all have the same sign in each said one or more spectral configuration's respective parameter of interest sensitivity data, said parameter of interest sensitivity data describing a variation of parameter of interest sensitivity with angle, for each of said one or more different spectral configurations.

14. An illumination module as defined in clause 13, wherein said one or more different spectral configurations comprise a first wavelength and a second wavelength which have a substantially complementary respective parameter of interest sensitivity data, such that positive parameter of interest sensitivity regions in parameter of interest sensitivity data related to said first wavelength substantially correspond in terms of illumination angle with negative sensitivity regions in parameter of interest sensitivity data related to said second wavelength and *vice versa*.

15. An illumination module as defined in clause 14, wherein the first wavelength and second wavelength are separated by a difference determined from a thickness of the diffractive structure and an angle of incidence of the measurement illumination on the diffractive structure.

16. An illumination module as defined in any preceding clause, wherein a range of detection angles defined by said detection numerical aperture is fixed.

17. An illumination module as defined any of clauses 1 to 15, wherein said a range of detection angles defined by said detection numerical aperture may be varied in dependence with said illumination angle and/or spectral configuration.

18. An illumination module for a metrology device comprising:

   a beam steering device for scanning a beam of said measurement illumination over said range of illumination angles during a measurement so as to provide measurement illumination over a configurable range of illumination angles;
   a color selection module for controllably configuring a spectral configuration of said measurement illumination; and
   a controller operable to control said beam steering device and said color selection module such that said spectral configuration of said measurement illumination is varied in dependence with illumination angle within said range of illumination angles so as to obtain a desired detection condition for detection of diffracted radiation from a diffractive structure resultant from a measurement of the diffractive structure using said measurement illumination.

19. An illumination module as defined in clause 18, wherein a desired detection condition comprises substantially filling a detection numerical aperture with wanted diffracted order radiation resulting from said measurement of the diffractive structure, for each of a plurality of desired wavelengths of said measurement illumination.

20. An illumination module as defined in clause 19, wherein the controller is operable to:

   control said beam steering device to provide measurement illumination over a range of illumination angles corresponding to a substantially filled detection numerical aperture for each of the plurality of desired wavelengths; and

simultaneously control said color selection module to select, for each illumination angle within said range of illumination angles, all wavelengths of said plurality of desired wavelengths for which the wanted diffracted order radiation will be captured within said detection numerical aperture.

21. An illumination module as defined in clause 18, wherein a desired detection condition comprises, for each of a plurality of desired wavelengths of said measurement illumination, detecting within a detection numerical aperture only one or more wanted diffraction order radiation resulting from the measurement of the diffractive structure, and not detecting any unwanted diffraction order radiation resulting from the measurement of the diffractive structure.

22. An illumination module as defined in clause 21, wherein said unwanted diffraction order radiation comprises diffraction order radiation higher than a first diffraction order.

23. An illumination module as defined in any of clauses 19 to 22, wherein said wanted diffraction order radiation comprises one or more first diffraction orders.

24. An illumination module as defined in any preceding clause wherein said controller is operable to vary the spectral configuration of said measurement illumination during a single scan of said beam of said measurement illumination over said range of illumination angles in dependence with said with illumination angle.

25. An illumination module as defined in clause 24, wherein said desired detection condition comprises obtaining an average parameter of interest sensitivity magnitude for said measurement which is greater than 0.5 on a scale between 0 and 1.

26. An illumination module as defined in clause 25, wherein said parameter of interest is overlay.

27. An illumination module as defined in clause 25 or 26, wherein said controller is operable to control said configurable illumination module and said grating light valve module so as to select, for substantially each illumination angle of the range of illumination angles, only combinations of the spectral configuration and illumination angle of the measurement beam which maximize said average parameter of interest sensitivity value

28. An illumination module as defined in any of clauses 25 to 27, wherein said controller is operable to control said beam steering device and said color selection module so as to select, for substantially each illumination angle of the range of illumination angles, only combinations of the spectral configuration and illumination angle of the measurement beam that are associated with a respective parameter of interest sensitivity value having the same sign.

29. An illumination module as defined in clause 28, wherein said controller is operable, during a single scan of said beam of said measurement illumination, to select a respective spectral configuration of one or more different spectral configurations at illumination angles which correspond to parameter of interest sensitivity values which substantially all have the same sign in each said one or more spectral configuration's respective parameter of interest sensitivity data, said parameter of interest sensitivity data describing a variation of parameter of interest sensitivity with angle, for each of said one or more different spectral configurations.

30. An illumination module as defined in clause 29, wherein said one or more different spectral configurations comprise a first wavelength and a second wavelength which have a substantially complementary respective parameter of interest sensitivity data, such that positive parameter of interest sensitivity regions in parameter of interest sensitivity data related to said first wavelength substantially correspond in terms of illumination angle with negative sensitivity regions in parameter of interest sensitivity data related to said second wavelength and *vice versa*.

31. An illumination module as defined in clause 30, wherein the first wavelength and second wavelength are separated by a difference determined from a thickness of the diffractive structure and an angle of incidence of the measurement illumination on the diffractive structure.

32. An illumination module as defined in any of clauses 17 to 31, wherein a range of detection angles defined by said detection numerical aperture is fixed.

33. An illumination module as defined in any of clause s 17 to 31, wherein said a range of detection angles defined by said detection numerical aperture may be varied in dependence with said illumination angle and/or spectral configurations.

34. A method of measuring a diffractive structure with measurement illumination selectively comprising a plurality of desired wavelengths, the method comprising:

scanning a beam of said measurement illumination over a range of illumination angles corresponding to a substantially filled detection numerical aperture for each of the plurality of desired wavelengths so as to illuminate said diffractive structure; and

during said scanning, for each illumination angle within said range of illumination angles, selecting all wavelengths of said plurality of desired wavelengths for which wanted diffracted order radiation, diffracted by said diffractive structure, will be captured within said detection numerical aperture.

35. A method as defined in clause 34, wherein said wanted diffraction order radiation comprises one or more first diffraction orders.

36. An method as defined in clause 34 or 35, wherein a range of detection angles defined by said detection numerical aperture is fixed.

37. An method as defined in clause 34 or 35, comprising varying a range of detection angles defined by said detection numerical aperture in dependence with said illumination angle and/or wavelength.

38. A method of measuring a diffractive structure with measurement illumination, the method comprising:

scanning a beam of said measurement illumination over a range of illumination angles so as to illuminate said diffractive structure; and

during said scanning, for each illumination angle within said range of illumination angles, selecting only combinations of a spectral configuration of the measurement beam and illumination angle of the measurement beam that are associated with a respective parameter of interest sensitivity value having the same sign.

39. A method as defined in clause 38, wherein said parameter of interest is overlay.

40. A method as defined in clause 38 or 39, comprising:

obtaining respective parameter of interest sensitivity data, describing a variation of parameter of interest sensitivity with angle, for each of one or more different spectral configurations; and

during a single scan of said beam of said measurement illumination, selecting a respective spectral configuration of said one or more different spectral configurations at illumination angles which correspond to parameter of interest sensitivity values which substantially all have the same sign in each said one or more spectral configuration's respective parameter of interest sensitivity data.

41. A method as defined in clause 40, wherein said one or more different spectral configurations comprise a first wavelength and a second wavelength which have a substantially complementary respective parameter of interest sensitivity data, such that positive parameter of interest sensitivity regions in parameter of interest sensitivity data related to said first wavelength substantially correspond in terms of illumination angle with negative sensitivity regions in parameter of interest sensitivity data related to said second wavelength and *vice versa.*

42. A method as defined in clause 41, comprising determining said first wavelength and second wavelength from a thickness of the diffractive structure and an angle of incidence of the measurement illumination on the diffractive structure.

43. A metrology device comprising the illumination module of any of clauses 1 to 33 configured to provide measurement illumination.

44. A metrology device as defined in clause 43, wherein the metrology device comprises a scatterometer.

45. A metrology device as defined in clause 43 or 44, comprising:

a support for a substrate;

an optical system for directing said measurement illumination to a diffractive structure on said substrate; and

a detector for detecting the measurement radiation scattered by the structure on the substrate.

It should be appreciated that the term color is used throughout this text synonymously with wavelength or spectral component and the colors may include those outside the visible band (e.g., infrared or ultraviolet wavelengths).

While specific embodiments of the invention have been described above, it will be appreciated that the invention may be practiced otherwise than as described.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultraviolet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The breadth and scope of the present invention should not be limited by any of the above-described exemplary embodiments, but should be defined only in accordance with the following claims and their equivalents.

**Claims**

1. An illumination module for a metrology device comprising:

   a beam steering device for scanning a beam of said measurement illumination over said range of illumination angles during a measurement so as to provide measurement illumination over a configurable range of illumination angles;
   a color selection module for controllably configuring a spectral configuration of said measurement illumination; and
   a controller operable to control said beam steering device and said color selection module such that said spectral configuration of said measurement illumination is varied in dependence with illumination angle within said range of illumination angles so as to obtain a desired detection condition for detection of diffracted radiation from a diffractive structure resultant from a measurement of the diffractive structure using said measurement illumination.

2. An illumination module as claimed in claim 1, wherein a desired detection condition comprises substantially filling a detection numerical aperture with wanted diffracted order radiation resulting from said measurement of the diffractive structure, for each of a plurality of desired wavelengths of said measurement illumination.

3. An illumination module as claimed in claim 2, wherein the controller is operable to:

   control said beam steering device to provide measurement illumination over a range of illumination angles corresponding to a substantially filled detection numerical aperture for each of the plurality of desired wavelengths; and
   simultaneously control said color selection module to select, for each illumination angle within said range of illumination angles, all wavelengths of said plurality of desired wavelengths for which the wanted diffracted order radiation will be captured within said detection numerical aperture.

4. An illumination module as claimed in claim 1, wherein a desired detection condition comprises, for each of a plurality of desired wavelengths of said measurement illumination, detecting within a detection numerical aperture only one or more wanted diffraction order radiation resulting from the measurement of the diffractive structure, and not detecting any unwanted diffraction order radiation resulting from the measurement of the diffractive structure.

5. An illumination module as claimed in claim 4, wherein said unwanted diffraction order radiation comprises diffraction order radiation higher than a first diffraction order.

6. An illumination module as claimed in any of claims 2 to 5, wherein said wanted diffraction order radiation comprises one or more first diffraction orders.

7. An illumination module as claimed in any preceding claim wherein said controller is operable to vary the spectral configuration of said measurement illumination during a single scan of said beam of said measurement illumination over said range of illumination angles in dependence with said with illumination angle.

8. An illumination module as claimed in claim 7, wherein said desired detection condition comprises obtaining an average parameter of interest sensitivity magnitude for said measurement which is greater than 0.5 on a scale between 0 and 1.

9. An illumination module as claimed in claim 8, wherein said parameter of interest is overlay.

10. An illumination module as claimed in claim 8 or 9, wherein said controller is operable to control said configurable illumination module and said grating light valve module so as to select, for substantially each illumination angle of the range of illumination angles, only combinations of the spectral configuration and illumination angle of the measurement beam which maximize said average parameter of interest sensitivity value

11. An illumination module as claimed in any of claims 8 to 10, wherein said controller is operable to control said beam steering device and said color selection module so as to select, for substantially each illumination angle of the range of illumination angles, only combinations of the spectral configuration and illumination angle of the measurement beam that are associated with a respective parameter of interest sensitivity value having the same sign.

12. An illumination module as claimed in claim 11, wherein said controller is operable, during a single scan of said beam of said measurement illumination, to select a respective spectral configuration of one or more different spectral configurations at illumination angles which correspond to parameter of interest sensitivity values which substantially all have the same sign in each said one or more spectral configuration's respective parameter of interest sensitivity data, said parameter of interest sensitivity data describing a variation of parameter of interest sensitivity with angle, for each of said one or more different spectral configurations.

13. An illumination module as claimed in claim 12, wherein said one or more different spectral configurations comprise a first wavelength and a second wavelength which have a substantially complementary respective parameter of interest sensitivity data, such that positive parameter of interest sensitivity regions in parameter of interest sensitivity data related to said first wavelength substantially correspond in terms of illumination angle with negative sensitivity regions in parameter of interest sensitivity data related to said second wavelength and *vice versa.*

14. A method of measuring a diffractive structure with measurement illumination selectively comprising a plurality of desired wavelengths, the method comprising:

scanning a beam of said measurement illumination over a range of illumination angles corresponding to a substantially filled detection numerical aperture for each of the plurality of desired wavelengths so as to illuminate said diffractive structure; and
during said scanning, for each illumination angle within said range of illumination angles, selecting all wavelengths of said plurality of desired wavelengths for which wanted diffracted order radiation, diffracted by said diffractive structure, will be captured within said detection numerical aperture.

15. A metrology device comprising the illumination module of any of claims 1 to 13 configured to provide measurement illumination.

Fig. 1

Fig. 2

LA

SC1

SC3

CL

0

-1    +1

MT

SC2

Fig. 3

2

4

SM1

Z

X

PU

W

I

6

λ

Z

8

X

Fig. 4

Fig. 5

Fig. 6

Fig. 7

Fig. 8

Fig. 9

Fig. 10

Fig. 11

Fig. 12

Fig. 13

EP 4 279 994 A1

Fig. 14

Europäisches
Patentamt

European
Patent Office

Office européen
des brevets

## EUROPEAN SEARCH REPORT

Application Number

EP 22 17 4619

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/082932 A1 (FU JIYOU [US] ET AL) 23 March 2017 (2017-03-23) | 1-11,14, 15 | INV. G03F7/20 |
| Y | * paragraphs [0058] – [0075]; figures 1,2 * | 12,13 | G01N21/88 |
| | * paragraphs [0088] – [0092]; figure 16 * | | G01N21/95 |
| | * paragraph [0115] * | | G01N21/956 |
| | * paragraph [0156] * | | |
| | * paragraph [0172] * | | |
| | * paragraph [0220] * | | |
| | ----- | | |
| Y | US 2002/018205 A1 (ASPNES DAVID E [US] ET AL) 14 February 2002 (2002-02-14) * paragraphs [0029] – [0048]; figures 1-3 * | 12,13 | |
| | ----- | | |
| A | US 2013/114085 A1 (WANG DAVID Y [US] ET AL) 9 May 2013 (2013-05-09) * paragraph [0008] * * paragraphs [0027] – [0041]; figures 1-3 * | 1-15 | |
| | ----- | | |

TECHNICAL FIELDS
SEARCHED        (IPC)

G03F
G01N

The present search report has been drawn up for all claims

| Place of search | Date of completion of the search | Examiner |
|---|---|---|
| Munich | 16 November 2022 | van Toledo, Wiebo |

EPO FORM 1503 03.82 (P04C01)

## ANNEX TO THE EUROPEAN SEARCH REPORT
## ON EUROPEAN PATENT APPLICATION NO.

EP 22 17 4619

16-11-2022

| Patent document cited in search report | | Publication date | Patent family member(s) | | Publication date |
|---|---|---|---|---|---|
| US 2017082932 | A1 | 23-03-2017 | CN | 108027568 A | 11-05-2018 |
| | | | IL | 257866 A | 31-05-2018 |
| | | | JP | 6830492 B2 | 17-02-2021 |
| | | | JP | 2018535560 A | 29-11-2018 |
| | | | KR | 20180045026 A | 03-05-2018 |
| | | | TW | 201721308 A | 16-06-2017 |
| | | | US | 2017082932 A1 | 23-03-2017 |
| | | | WO | 2017053581 A1 | 30-03-2017 |
| US 2002018205 | A1 | 14-02-2002 | DE | 69716272 T2 | 26-06-2003 |
| | | | EP | 0914600 A1 | 12-05-1999 |
| | | | EP | 1197741 A2 | 17-04-2002 |
| | | | ES | 2185038 T3 | 16-04-2003 |
| | | | JP | 4140737 B2 | 27-08-2008 |
| | | | JP | 2000515247 A | 14-11-2000 |
| | | | US | 5877859 A | 02-03-1999 |
| | | | US | 5973787 A | 26-10-1999 |
| | | | US | 6134012 A | 17-10-2000 |
| | | | US | 6320657 B1 | 20-11-2001 |
| | | | US | 2002018205 A1 | 14-02-2002 |
| | | | US | 2002191186 A1 | 19-12-2002 |
| | | | US | 2004042009 A1 | 04-03-2004 |
| | | | WO | 9803853 A1 | 29-01-1998 |
| US 2013114085 | A1 | 09-05-2013 | NONE | | |

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006033921 A1
- US 2010201963 A1
- US 2006066855 A1
- WO 2009078708 A
- WO 2009106279 A
- US 20110027704 A
- US 20110043791 A
- US 2011102753 A1
- US 20120044470 A
- US 20120123581 A
- US 20130258310 A
- US 20130271740 A
- WO 2013178422 A1
- US 6952253 B
- US 20100328655 A
- US 20110249244 A

- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- US 20160161863 A
- US 20160370717 A1
- US 6947613 B